(19) Europäisches Patentamt / European Patent Office / Office européen des brevets

(11) **EP 1 745 531 B1**

(12) **FASCICULE DE BREVET EUROPEEN**

(45) Date de publication et mention
de la délivrance du brevet:
**08.04.2009 Bulletin 2009/15**

(21) Numéro de dépôt: **05759811.2**

(22) Date de dépôt: **02.05.2005**

(51) Int Cl.:
*H01S 3/0941* (2006.01)  *H01S 5/183* (2006.01)
*H01S 3/02* (2006.01)  *H01S 5/022* (2006.01)
*H01S 5/04* (2006.01)

(86) Numéro de dépôt international:
**PCT/FR2005/050292**

(87) Numéro de publication internationale:
**WO 2005/109584 (17.11.2005 Gazette 2005/46)**

(54) **EMETTEUR DE RAYONNEMENT AVEC FAISCEAU DE POMPAGE INCLINE**

STRAHLUNGSEMITTER MIT GENEIGTEM PUMPSTRAHL

INCLINED PUMP BEAM RADIATION EMITTER

(84) Etats contractants désignés:
AT BE BG CH CY CZ DE DK EE ES FI FR GB GR
HU IE IS IT LI LT LU MC NL PL PT RO SE SI SK TR

(30) Priorité: **04.05.2004 FR 0404803**

(43) Date de publication de la demande:
**24.01.2007 Bulletin 2007/04**

(73) Titulaire: **COMMISSARIAT A L'ENERGIE
ATOMIQUE**
**75015 Paris (FR)**

(72) Inventeurs:
• **ROTHMAN, Johan**
**F-38000 Grenoble (FR)**
• **PICARD, Emmanuel**
**F-38410 Saint Martin d'Uriage (FR)**

(74) Mandataire: **Poulin, Gérard et al**
**BREVALEX**
**3, rue du Docteur Lancereaux**
**75008 Paris (FR)**

(56) Documents cités:
WO-A-02/47223  US-A- 5 513 204
US-A1- 2001 012 307  US-A1- 2001 043 636

• HEUMANN E ET AL: "DIODE-PUMPED CONTINUOUS-WAVE GREEN UPCONVERSION LASING OF ER3+:LILUF4 USING MULTIPASS PUMPING" OPTICS LETTERS, OPTICAL SOCIETY OF AMERICA, WASHINGTON, US, vol. 27, no. 19, 1 octobre 2002 (2002-10-01), pages 1699-1701, XP001161782 ISSN: 0146-9592
• HADJI E ET AL: "3.3- MUM MICROCAVITY LIGHT EMITTER FOR GAS DETECTION" OPTICS LETTERS, OPTICAL SOCIETY OF AMERICA, WASHINGTON, US, vol. 25, no. 10, 15 juin 2000 (2000-06-15), pages 725-727, XP000951922 ISSN: 0146-9592
• ROUX C ET AL: "II-VI infrared microcavity emitters with 2 postgrowth dielectric mirrors" JOURNAL OF CRYSTAL GROWTH, NORTH-HOLLAND PUBLISHING CO. AMSTERDAM, NL, vol. 201-202, mai 1999 (1999-05), pages 1036-1039, XP004175293 ISSN: 0022-0248

**Description**

**DOMAINE TECHNIQUE ET ART ANTERIEUR**

L'invention concerne le domaine des émetteurs de lumière.

Elle concerne notamment la réalisation d'émetteurs de lumière Infra Rouge pouvant être utilisés, par exemple, pour la détection de gaz et le tri des plastiques.

Un tel émetteur peut être aussi utilisé pour détecter des gaz polluants dans les pots d'échappement des voitures.

La détection du gaz par moyen optique dans la gamme de longueur d'onde de 3-5 $\mu$m présente de nombreux avantages :

- les raies d'absorption sont intenses,
- les raies d'absorption sont, pour les gaz les plus importants, bien séparées en longueurs d'onde.

La difficulté d'utiliser cette gamme de longueurs d'onde est qu'il y a peu de sources disponibles, suffisamment intenses et directionnelles.

Les lasers basés sur des effets de cascade quantique sont trop coûteux et très complexes à réaliser.

Des filaments filtrés ont des intensités faibles mais peuvent être utilisés en combinaison avec une détection synchrone.

Cependant, ils sont trop lents pour permettre une modulation directe et nécessitent une modulation mécanique de la lumière, ce qui est trop volumineux et fragile pour la plupart des applications.

L'utilisation des microcavités résonnantes à base de CdHgTe comme source a été proposé par E. Hadji et E. Picard dans le document FR-0116116, avec de nombreux avantages :

- faible coût,
- faible encombrement,
- longueur d'onde ajustable et de faible largeur spectrale,
- la source est suffisamment rapide pour une modulation directe.

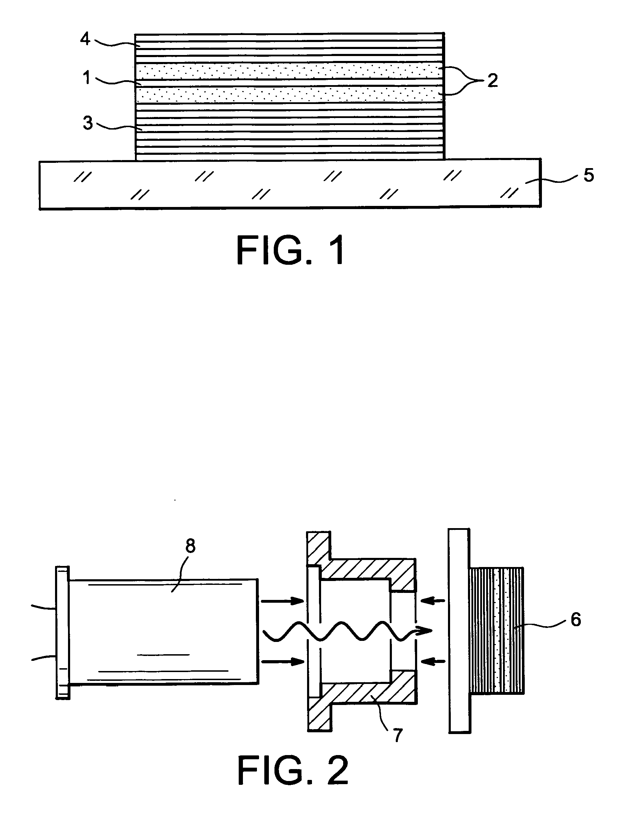

La microcavité utilisée dans un tel émetteur est illustrée schématiquement sur la figure 1. Une couche émettrice 1 est mise en sandwich entre deux couches barrières 2 et deux miroirs de Bragg 3 et 4. La cavité repose sur un substrat 5, pour des raisons mécaniques.

Les couches 2 de barrière servent à créer des photo-porteurs par l'absorption des photons d'une diode laser de pompe.

L'émission IR est générée par la recombinaison des photo-porteurs dans la couche émettrice 1.

L'émission de la microcavité est notamment déterminée par l'absorption de la diode laser pompe. Les épaisseurs de couches dans la cavité sont en outre adaptées afin que la cavité soit résonnante à la longueur d'onde de l'émission.

Typiquement, les épaisseurs des barrières 2 sont telles que à peu près 60 % de la lumière de pompe est absorbée dans la cavité, limitant ainsi la puissance émise de l'émetteur.

La figure 2 illustre un exemple d'un système émetteur standard. Une microcavité 6 est montée sur une structure de montage 7 qui permet d'assembler la microcavité avec des moyens 8 de pompage, par exemple une diode laser.

La fabrication et le fonctionnement de telles microcavités sont décrits dans le document FR-0116116.

Deux phénomènes limitent la puissance émise par ces dispositifs connus.

Une partie du rayonnement de la diode laser pompe est réfléchie par le miroir d'entrée de la cavité 6.

Une part de la puissance optique de la diode laser de pompe peut donc être réfléchie dans cette même diode, créant ainsi des instabilités de puissance. La lumière réfléchie représente une perte d'intensité des faisceaux de pompage et provoque, ainsi, une perte de l'émission de l'émetteur.

Cette lumière réfléchie peut aussi engendrer des instabilités de la diode de pompe 8. Ce problème peut être résolu en choisissant une longueur d'onde de la diode de pompage, qui sera moins réfléchie, avec le désavantage d'un coût supplémentaire engendré par le développement d'une diode de pompage spécifique pour chaque longueur d'onde.

Par ailleurs, une partie seulement de la puissance de la diode de pompage est absorbée dans la couche 1, à cause de l'épaisseur finie des couches barrières 2.

**EXPOSÉ DE L'INVENTION**

L'invention propose un système qui permet d'optimiser l'émission d'un émetteur de lumière par l'optimisation ou l'amélioration de la transmission d'un faisceau de pompage à travers un miroir d'entrée de l'émetteur et/ou l'optimisation ou l'amélioration de l'absorption, dans une cavité résonnante de l'émetteur, d'un faisceau de pompage d'une diode de pompage utilisée pour exciter optiquement des porteurs dans le dispositif émetteur.

Selon un premier aspect, l'invention concerne un dispositif d'émission de rayonnement par pompage optique comprenant :

- des moyens d'émission de lumière comportant une première cavité résonnante présentant un premier miroir d'entrée et un miroir de sortie,
- des moyens de pompage optique pour émettre un faisceau de pompage de la première cavité, la normale à la face d'entrée de la cavité résonnante étant inclinée, par rapport à la direction de propagation du faisceau de pompage d'un angle θ non nul, ou comporte des moyens ou des moyens d'inclinaison pour former un angle θ non nul avec cette direction de propagation,
- des moyens pour former une deuxième cavité résonnante pour le faisceau de pompage, lesdits moyens comportant un deuxième miroir d'entrée formant ladite deuxième cavité avec le miroir de sortie de la première cavité, caractérisé en ce qu'il comporte un élément optique, transparent à la longueur d'onde de pompage, peut être prévu entre les premier et deuxième miroirs d'entrée. Cet élément optique permet d'optimiser la longueur de la deuxième cavité pour une longueur d'onde de pompage donnée.

Selon un mode de réalisation, la cavité résonnante est inclinée d'un angle θ tel que le faisceau de pompage soit transmis dans la première cavité à travers la face d'entrée avec une transmission supérieure à 50%.

Les miroirs peuvent être de type de Bragg ou métalliques.

Les réflectivités $R_E$ et $R_S$ des deuxièmes miroirs d'entrée et du miroir de sortie à la longueur d'onde de la diode laser pompe $\lambda_p$ satisfont de préférence à la condition :

$$R_E = R_S \exp\left(-2\alpha d / \cos\theta'\right),$$

où $\alpha$ est le coefficient d'absorption à la longueur d'onde de pompage, d est l'épaisseur absorbante et θ' l'angle de propagation par rapport à la normale, de la lumière dans un milieu absorbant.

L'absorption du faisceau de pompage dans la deuxième cavité peut être supérieure à 50%.

De préférence le rayonnement est émis majoritairement selon le mode fondamental de la deuxième cavité résonnante.

Les moyens de pompage optique peuvent avantageusement comporter au moins un VCSEL.

Le faisceau de rayonnement émis par la première cavité résonante peut avoir un diamètre inférieur à 200 $\mu$m.

La longueur d'onde d'émission de la première cavité est par exemple au moins partiellement comprise entre 2 $\mu$m et 10 $\mu$m.

L'invention concerne également un dispositif optique comportant un dispositif tel que décrit ci-dessus et une fibre optique couplée avec la sortie de la première cavité résonnante.

L'invention propose donc divers moyens pour augmenter la puissance émise pour une puissance donnée d'une diode de pompage, par l'optimisation de la transmission et/ou de l'absorption du faisceau de la diode de pompage.

Elle permet aussi d'optimiser cette absorption dans le cas d'une longueur d'onde de laser de pompage ajustable.

L'invention propose aussi divers moyens d'assemblage de la diode de pompage et de l'émetteur.

Elle concerne un dispositif de support comportant des moyens pour maintenir un angle θ non nul, par exemple compris entre 10° et 30°, entre une direction de propagation d'un faisceau de pompage d'un moyen de pompage d'une cavité résonnante et une normale à une face ou à un miroir d'entrée de cette cavité.

L'invention concerne donc également un dispositif ou un support de montage d'un dispositif d'émission de rayonnement et de moyens de pompage optique pour émettre un faisceau de pompage comportant:

- des moyens pour maintenir lesdits moyens de pompage dans le dispositif de montage,
- des moyens pour maintenir un dispositif d'émission de rayonnement, de sorte que la normale à la face d'entrée de ces moyens d'émission de rayonnement est inclinée d'un angle θ par rapport à la direction de propagation d'un faisceau de pompage provenant desdits moyens de pompage optique.

Selon l'invention, on peut donc réaliser un dispositif ou un support comportant deux faces, sur lesquelles les moyens de pompage et les moyens d'émission sont destinés à être montés, ces faces faisant entre elles un angle θ. Ce support peut être par exemple le substrat de croissance d'un VCSEL de pompage.

Les moyens pour maintenir les moyens de pompage peuvent comporter une excavation pratiquée dans dispositif d'assemblage.

L'excavation peut être à symétrie de révolution autour d'un axe parallèle à un axe longitudinal du dispositif d'assemblage.

Dans ce cas, une surface d'extrémité de ce dispositif d'assemblage peut définir un plan ayant une normale inclinée d'un angle θ par rapport à cet axe longitudinal.

L'excavation peut être inclinée d'un angle θ par rapport à un axe longitudinal du dispositif d'assemblage.

Dans ce cas, une surface d'extrémité de ce dispositif d'assemblage définit un plan normal par rapport à cet axe longitudinal.

L'invention propose donc divers moyens d'assemblage d'une microcavité avec des moyens de pompage laser, qui permettent de :

a) optimiser l'émission de l'émetteur par l'optimisation de l'absorption de la pompe laser.
b) supprimer les instabilités dans la pompe dues aux réflexions du faisceau de pompage sur la surface de l'émetteur.

L'angle θ permet d'éviter la réflexion de la lumière du faisceau de pompage dans la cavité, éliminant ainsi les instabilités dans les moyens de pompage.

L'angle θ est de préférence choisi pour optimiser l'absorption de la pompe quand la longueur d'onde est fixée.

## BRÈVE DESCRIPTION DES FIGURES

- Les figures 1 et 2 représentent un dispositif selon l'art antérieur,
- les figures 3 et 4 sont des courbes de transmission et d'absorption en fonction de l'angle d'incidence d'un faisceau de pompage,
- les figures 5 - 9 représentent divers modes de réalisation de l'invention.

## EXPOSÉ DÉTAILLÉ DE MODES DE RÉALISATION PARTICULIERS

L'invention s'applique à un dispositif émetteur de lumière, cohérente ou non, tel que par exemple illustré sur la figure 1. Un tel dispositif est pompé optiquement à l'aide des moyens de pompage.

La couche émettrice 1 est par exemple en $Cd_x\,Hg_{1-x}$ Te ($0,2 \leq x \leq 0,5$), les couches barrières 2 en $Cd_x\,Hg_{1-x}$ Te avec x = 0, 65, les miroirs 3, 4 en $YF_3ZnS$, ou $YF_3Si$....

Le matériau de la couche émettrice peut donc être en $Hg_{1-x}Cd_xTe$. D'autres exemple de matériaux utilisables sont les semi-conducteurs III-IV ($InAs_{1-x}Sb_x$, ou $Ga_{1-x}In_xSb$ ou $Ga_{1-x}In_xAs_{1-y}Sb_y$) ou les semi-conducteurs de type IV-VI ($Pb_{1-x}Sn_xTe$ ou $Pb_{1-x}Sn_xSe$).

Un premier mode de réalisation de l'invention concerne l'optimisation de l'absorption du faisceau de pompage par l'optimisation ou la maximisation de la transmission du faisceau de pompage à travers le miroir d'entrée d'une cavité telle que celle illustrée en figure 1.

La transmission d'un miroir de Bragg dépend de l'empilement des couches de ce miroir, des épaisseurs et des indices de ces couches, de la longueur d'onde du rayonnement mais aussi de l'angle d'incidence du rayonnement.

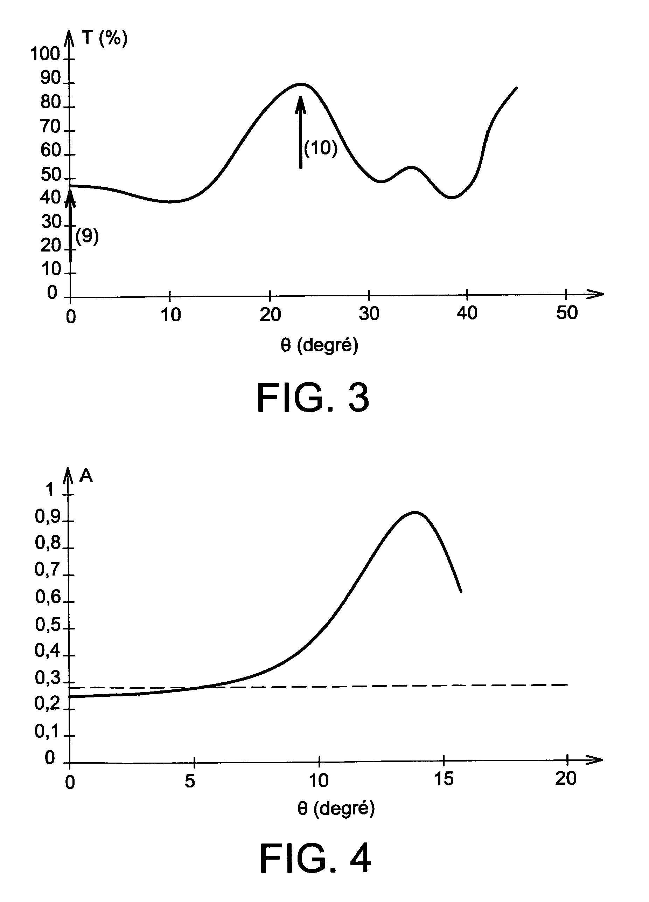

La figure 3 montre la transmission d'un miroir de Bragg pour un faisceau émis par une diode de pompage, de longueur d'onde $\lambda p = 830$ nm, en fonction de l'angle θ d'incidence, c'est-à-dire de l'angle entre la direction de propagation du faisceau de pompage et la normale au miroir d'entrée de la cavité, ce miroir étant optimisé pour une réflexion maximale à $\lambda$ émission = 3,3 $\mu$m (il s'agit de la longueur d'onde, ou de la longueur d'onde principale, du faisceau émis par la cavité).

La flèche 9 indique la transmission à l'angle d'incidence normale θ = 0° : T = 45 %.

Un changement de l'angle d'incidence augmente le chemin optique entre les interfaces de chaque couche du miroir de Bragg et permet de changer la transmission à travers ce miroir.

Un miroir qui est optimisé pour une réflexion maximale de l'émetteur à une longueur d'onde d'émission, $\lambda_E$, peut ainsi être rendu le plus transparent possible pour la longueur d'onde de la diode laser pompe. On peut aussi réaliser une telle optimisation si on a un autre type de miroir, en entrée, qu'un miroir de Bragg.

De préférence, l'angle θ est choisi tel que la transmission du faisceau de pompage se trouve dans un maximum de transmission, par exemple supérieur à 70% ou à 80% ou à 85%, comme indiqué par la flèche 10 de la figure 3.

Ce choix permet aussi de rendre le système moins sensible aux fluctuations introduites pendant la fabrication, aux incertitudes sur l'angle d'incidence ou sur les épaisseurs des couches dans le miroir, et à la valeur de la longueur d'onde de pompage.

Mais l'angle θ peut aussi être choisi tel que la transmission T du faisceau de pompage soit supérieure à 50%. Sur la figure 3 cela correspond à un angle compris entre environ 13° et 29°.

De plus, en modifiant la structure du miroir diélectrique, on peut avantageusement transformer la courbe de transmission de façon à obtenir un profil plus carré, c'est-à-dire avec une plage de transmission supérieure à 50%, plus homogène, tout en conservant la réflectivité optimale pour la longueur d'onde d'émission de la cavité.

Selon un autre mode de réalisation, on procède à l'optimisation de l'absorption du faisceau de pompage par mise en résonance de ce faisceau.

Dans cette configuration, la puissance de la diode laser pompe absorbée dans la cavité peut être optimisée de la manière suivante.

L'angle d'incidence est choisi pour ajuster un chemin optique du faisceau provenant des moyens de pompage dans la cavité définie par les miroirs d'entrée et de sortie de la cavité, de sorte que la cavité devienne résonante aussi pour la longueur d'onde de la diode laser pompe.

Dans le cas simple d'une cavité homogène et en négligeant le déphasage qui peut être introduit par les miroirs, l'angle θ d'incidence est de préférence choisi tel que le rapport k suivant soit entier :

$$k \; = \; \frac{2ne\cos\theta'}{\lambda_p}, \qquad (1)$$

où n est l'indice optique dans la cavité, e l'épaisseur de la cavité (mesurée perpendiculairement au plan des miroirs), $\lambda_p$ la longueur d'onde de la pompe et θ' est l'angle de propagation, par rapport à la normale au miroir d'entrée de la cavité, de la lumière dans le milieu absorbant.

La réflectivité des miroirs d'entrée 3 et de sortie 4 ($R_E$ et $R_S$, respectivement) à la longueur d'onde de la diode laser pompe $\lambda_p$ peut, en outre, être optimisée pour une absorption maximale des faisceaux de la diode laser de pompage dans la cavité.

L'effet résonnant est optimal pour $R_S$ maximal, et :

$$R_E \; = \; R_S \, \exp\left(-2\alpha d \big/ \cos\theta'\right) \qquad (2)$$

où α est le coefficient d'absorption et d est l'épaisseur absorbante, mesurée perpendiculairement aux plans des miroirs et où θ' a été défini ci-dessus. Pour Rs non maximal, on peut encore utiliser cette formule.

L'optimisation peut aussi être effectuée avec la contrainte que les réflectivités $R_e$ et $R_s$ ne soient pas affectées pour la longueur d'onde d'émission de la cavité laser.

D'autre types de miroirs que les miroirs de Bragg, par exemple des miroirs métalliques, permettent aussi d'assurer une grande réflectivité à la fois pour la longueur d'onde de la pompe et de l'émission.

L'optimisation peut aussi s'effectuer en adaptant la valeur de αd, par exemple en modifiant l'épaisseur de l'absorbant (adaptation de d) ou en choisissant un autre matériau (adaptation de α).

La figure 4 montre un exemple d'absorption A dans une cavité en fonction de l'angle d'incidence θ, calculée pour une cavité émettant à λ=3,3 μm et avec (1-exp (-αd)) = 0,27, $R_E$ = 0,36 et $R_S$ = 0,90.

A θ =14° on observe une résonance avec une absorption > 90 %, à comparer avec l'absorption en transmission normale, sans réflexion à l'entrée et à la sortie, de 27 %, indiquée par la ligne en pointillés, de la figure 4. Selon l'invention, on peut établir, en sélectionnant l'angle d'incidence, une absorption comprise entre, par exemple, 40% ou 50% et 90%.

Un gain important de puissance absorbée peut ainsi être obtenu.

De plus, cette résonance permet d'utiliser des épaisseurs faibles de couches absorbantes donc des cavités peu épaisses. Il est donc possible d'émettre dans le mode fondamental (n fois plus puissant que le mode d'ordre n), ce qui permet d'augmenter l'efficacité de la cavité pour l'émission.

Ainsi, l'efficacité de l'émission peut être optimisée par augmentation de l'absorption.

Selon un autre mode de réalisation, on procède à l'optimisation de la transmission de la diode laser de pompe par l'ajustement de l'angle d'incidence (en vue d'une bonne transmission à travers le miroir d'entrée de la cavité émettrice, comme expliqué ci-dessus) et par l'optimisation de l'absorption du faisceau de pompage en créant une deuxième cavité résonnante à la longueur d'onde de pompage.

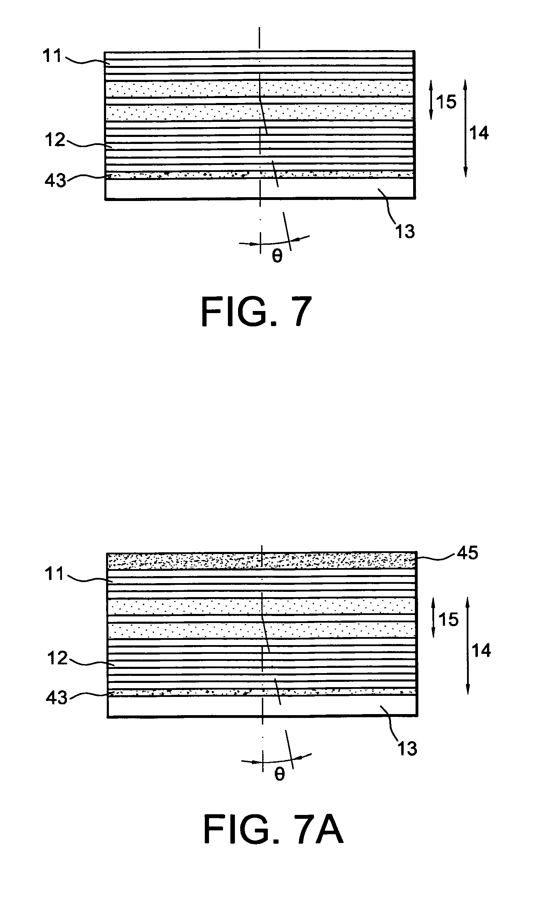

La figure 7 montre un émetteur ayant deux miroirs d'entrée 12, 13, côtés diode laser pompe, et un miroir de sortie 11 côté émission, formant deux cavités.

Une première cavité d'émission 15 est formée entre le miroir de Bragg d'entrée 12 et le miroir de sortie 11.

La deuxième cavité 14 est formée entre le deuxième miroir d'entrée 13 et le miroir de sortie 11.

L'angle d'incidence θ et la longueur d'onde $\lambda_p$ de la diode laser de pompe sont ajustés de sorte que :

a) le miroir de Bragg 12 à l'entrée de la cavité de l'émetteur soit le plus transparent possible, à la longueur d'onde $\lambda_p$ et,
b) la cavité 14 formée entre le miroir de sortie 11 de l'émetteur et le miroir d'entrée supplémentaire 13, forme une cavité résonnante pour la longueur d'onde $\lambda_p$ de la diode laser de pompe sous incidence θ.

Les miroirs d'entrée et de sortie 11, 13 de la cavité 14 pour la diode laser de pompe respectent de préférence la condition (2) de maximum d'absorption donnée ci-dessus et peuvent être de type Bragg ou métallique.

Ce procédé permet d'une part d'optimiser la transmission du miroir d'entrée pour le faisceau de pompage et, d'autre part, d'optimiser l'efficacité de ce dernier en vue du pompage de la cavité émettrice.

De plus, l'utilisation de miroirs d'entrée distincts pour la cavité du faisceau de pompage et la cavité d'émission rend plus facile l'optimisation de la réflectivité du miroir d'entrée 13 de la cavité du faisceau de pompage.

Aussi, l'épaisseur de la cavité de la diode laser de pompage, plus importante que celle de la cavité émettrice, facilite l'obtention d'une résonance de la pompe en fonction de l'angle et de la longueur d'onde $\lambda_p$ de la diode de pompage.

La résonance, dans la cavité 14, de la diode laser de pompage peut être obtenue en ajoutant une épaisseur d'un matériau d'un élément optique 43, transparent à la longueur d'onde de pompage $\lambda_p$, entre les deux miroirs d'entrée 12 et 13. On peut donc ajuster la longueur de la cavité 14. L'angle θ est alors choisi de manière à optimiser la transmission du miroir d'entrée 12 de la cavité d'émission.

L'efficacité du dispositif dépend aussi de la divergence de l'émission de la diode laser pompe. Une divergence minimale est donc préférable. Une lentille supplémentaire entre la diode laser pompe et l'émetteur peut être utilisée à cet effet dans certains cas, en particulier pour des diodes émettant par la tranche.

Il est également possible d'ajouter un miroir supplémentaire 45 sur le miroir de sortie 11, celui-ci est transparent à la longueur d'onde d'émission et réfléchissante à la longueur d'onde pompe, afin d'améliorer la résonance du faisceau de pompe (Figure 7a).

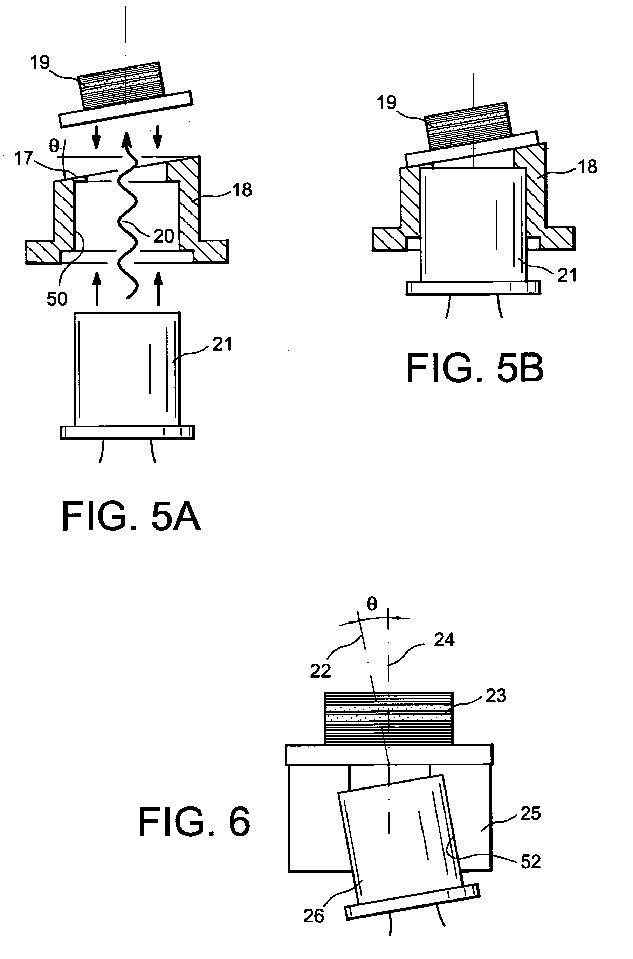

La figure 5A montre un exemple de réalisation d'un assemblage selon l'invention. L'émetteur 19 est collé sur la face avant d'une structure de montage 18.

La diode laser de pompe 21 est montée dans un trou ou une cavité 50, cylindrique dans cet exemple, adaptée à recevoir cette diode 21, côté face arrière de la structure de montage, et est centrée sur l'axe de la structure de montage.

L'angle θ est défini sur la face avant 17 de la structure de montage 18 et permet d'introduire l'angle optimal entre l'émetteur 19 et l'émission 20 de la diode de laser pompe 21 qui vient elle aussi s'appuyer sur la structure 18.

La figure 5B montre les différents composants assemblés.

La figure 6 représente une deuxième réalisation d'un assemblage, permettant d'introduire un angle optimal θ.

Par rapport à la première configuration, l'angle θ est introduit en inclinant le trou ou la cavité 52 de montage de la diode laser de pompe 26 dans la face arrière de la structure de montage 25.

L'émission de la diode laser pompe est dans ce cas inclinée selon un angle θ par rapport à l'axe de la structure de montage.

L'émetteur 23 est collé sur la face avant de la structure de montage 25 avec une normale à cet émetteur parallèle à l'axe 24 de cette structure de montage.

Dans ce cas, le lobe d'émission de l'émetteur 23 est centré sur l'axe de la structure de montage.

Cette deuxième réalisation a l'avantage de faciliter l'utilisation de la lumière émise par l'émetteur.

Par exemple, le couplage de la lumière dans une fibre optique peut dans ce cas s'effectuer facilement par un alignement passif, centré sur l'axe 24 de la structure de montage.

Il est également possible de réaliser un support ayant deux faces opposées, les moyens de pompage et les moyens d'émission étant chacun sur une de ces deux faces, qui font entre elles l'angle θ.

Dans une troisième réalisation d'un assemblage de l'émetteur avec la diode laser de pompe, on peut utiliser spécifiquement une diode laser pompe de type VCSEL (abréviation de Vertical Cavity Surface Emitting Laser), émettant par la face arrière.

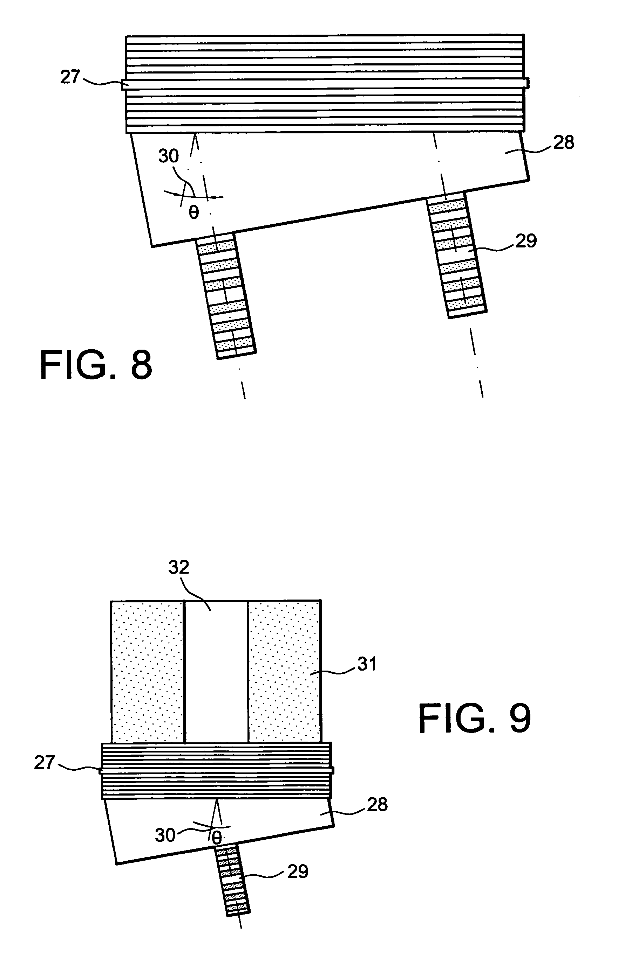

Cette réalisation est illustrée sur la figure 8. Dans cette réalisation, l'émetteur 27 est rapporté sur plaque directement sur la face arrière 28 d'un VCSEL 29. L'angle θ 30 entre la normale à l'émetteur 27 et la direction d'émission du VCSEL 29 est introduit par un polissage de la face arrière 28 de VCSEL 29, effectué soit avant, soit après la fabrication du VCSEL.

Cette réalisation apporte de nombreux avantages par rapport aux deux premières structures de montage :

- elle rend possible un couplage entre un émetteur 27 et des diodes de pompage, en collectif. Une grande réduction de coût d'assemblage est ainsi attendue.
- l'utilisation de VCSEL émettant par la face arrière, dont le faisceau est couplé directement dans l'émetteur, permet de minimiser la divergence de l'émission de la diode de pompage, rendant ainsi l'optimisation de l'émission de l'émetteur plus efficace, ce qui est encore renforcé par le choix de l'angle θ. Une lentille de collimation de l'émission de la diode laser pompe n'est pas nécessaire.
- l'émission de l'émetteur peut alors avoir lieu sur une surface réduite, déterminée par la taille du faisceau optique de la diode laser pompe, et, dans un deuxième ordre, par la longueur de diffusion des porteurs dans la cavité. La faible divergence du VCSEL et la proximité du couplage permettent de réduire la surface de l'émission de l'émetteur 27 à moins de 100 $\mu$m de diamètre. Cette taille est comparable avec le coeur de certaines fibres optiques, ce qui rend possible un couplage direct et complet de la lumière émise dans une fibre optique, sans utiliser des composants optiques supplémentaires.

Selon l'invention, on peut donc réaliser un dispositif ou un support comportant deux faces, sur lesquelles les moyens de pompage et les moyens d'émission sont destinés à être montés, ces faces faisant entre elles un angle $\theta$. Ce support peut être par exemple le substrat de croissance d'un VCSEL de pompage.

La figure 9 illustre un exemple de réalisation de couplage direct de la lumière dans le coeur 32 d'une fibre optique 31. La faible taille de la surface d'émission permet ainsi d'augmenter la lumière couplée dans une fibre optique et de réduire le coût du système, par réduction des composants nécessaires au montage et des étapes de montage.

Selon l'invention, on choisit un angle entre la propagation du faisceau de pompage et la normale de la surface de la microcavité émettrice.

L'invention permet d'augmenter la puissance émise, et de la stabiliser. Elle permet en outre une fabrication plus reproductible.

L'utilisation de VCSEL apporte des avantages supplémentaires :

- réduction de coût par la fabrication collective ;
- augmentation de la puissance optique utile par un couplage dans une fibre optique plus efficace ;
- réduction des composants optique(s) et mécanique(s) dans le système.

Les montages décrits en liaison avec les figures 5A-9 peuvent être mis en oeuvre dans l'un quelconque des dispositifs fonctionnant selon l'un des principes décrits ci-dessus de transmission optimale du miroir d'entrée et d'absorption optimale du faisceau de pompage par la cavité.

Les principes décrits (optimiseur de T, cavité résonnante à $\lambda_p$, ...) sont applicables à toute cavité émettrice, laser ou non.

Les dispositifs émetteurs selon l'invention émettent de préférence dans l'infra-rouge, par exemple entre 2 $\mu$m et 10 $\mu$m.

## Revendications

1. Dispositif d'émission de rayonnement par pompage optique comprenant :

   - des moyens (19, 23) d'émission de lumière comportant une première cavité résonnante présentant un premier miroir d'entrée (3, 12) et un miroir de sortie (4, 11),
   - des moyens (21 , 26) de pompage optique pour émettre un faisceau de pompage de la première cavité, la normale à la face d'entrée de la cavité résonnante étant inclinée d'un angle $\theta$ par rapport à la direction de propagation du faisceau de pompage (20),
   - des moyens (11, 13) pour former une deuxième cavité résonnante pour le faisceau de pompage, lesdits moyens comportant un deuxième miroir d'entrée (13) formant ladite deuxième cavité avec le miroir de sortie (11) de la première cavité, **caractérisé en ce qu'**il comporte un élément optique (43) transparent à la longueur d'onde de pompage entre les premier (12) et deuxième (13) miroirs d'entrée.

2. Dispositif selon la revendication 1, l'angle $\theta$ étant tel que le faisceau de pompage soit transmis dans la première cavité à travers le miroir d'entrée avec une transmission supérieure à 50%.

3. Dispositif selon l'une des revendications 1 à 2, comportant des miroirs de type Bragg ou métalliques.

4. Dispositif selon la revendication 1 à 3, l'angle $\theta$ étant tel que la deuxième cavité soit résonante à la longueur d'onde des moyens de pompage optique.

5. Dispositif selon la revendication 1 à 4, dans lequel les réflectivités $R_E$ et $R_S$ du deuxième miroir d'entrée (13) et du miroir de sortie (11) à la longueur d'onde de la diode laser pompe $\lambda_p$ satisfont à la condition :

$$R_E = R_S \exp\left(-2\alpha d \big/ \cos\theta'\right) \qquad (1)$$

où $\alpha$ est le coefficient d'absorption à la longueur d'onde de pompage et d est l'épaisseur absorbante, et $\theta'$ l'angle de la propagation, par rapport à la normale, de la lumière dans le milieu absorbant.

6. Dispositif selon l'une des revendications 1 à 5, l'absorption du faisceau de pompage dans la deuxième cavité étant supérieure à 50%.

7. Dispositif selon l'une des revendications 1 à 6, le rayonnement émis l'étant majoritairement selon le mode fondamental de la deuxième cavité résonnante.

8. Dispositif selon l'une des revendications 1 à 7, les moyens de pompage optique comportant au moins un VCSEL (29).

9. Dispositif selon la revendication 8, le faisceau de rayonnement émis par la première cavité résonnante ayant un diamètre inférieur à 200 $\mu$m.

10. Dispositif selon l'une des revendications 1 à 9, la longueur d'onde d'émission de la première cavité étant au moins partiellement comprise entre 2 $\mu$m et 10 $\mu$m.

11. Dispositif optique comportant un dispositif selon l'une des revendications 1 à 10 et une fibre optique (31) couplée avec la sortie de la première cavité résonnante.

12. Dispositif selon l'une quelconque des revendications 1 à 10, comportant un dispositif (18) de montage comprenant:

   - des moyens (50, 52) pour maintenir lesdits moyens de pompage dans le dispositif de montage,
   - des moyens pour maintenir le dispositif (19, 23) d'émission de rayonnement, de sorte que la normale à la face d'entrée de ces moyens d'émission de rayonnement soit inclinée d'un angle θ par rapport à la direction de propagation d'un faisceau de pompage provenant desdits moyens de pompage optique, **caractérisé en ce qu'**il comporte une première et une deuxième faces, pour maintenir les moyens de pompage et le dispositif d'émission de rayonnement, ces deux faces faisant entre elles un angle θ.

13. Dispositif selon l'une quelconque des revendications 1 à 10, comportant un dispositif (18) de montage comprenant :

   - des moyens (50, 52) pour maintenir lesdits moyens de pompage dans le dispositif de montage,
   - des moyens pour maintenir un dispositif (19, 23) d'émission de rayonnement, de sorte que la normale à la face d'entrée de ces moyens d'émission de rayonnement soit inclinée d'un angle θ par rapport à la direction de propagation d'un faisceau de pompage provenant desdits moyens de pompage optique, **caractérisé en ce qu'**il comporte le substrat de croissance d'un VCSEL de pompage.

14. Dispositif selon la revendication 12, dans lequel le dispositif (18) de montage comporte le substrat de croissance d'un VCSEL de pompage.

15. Dispositif selon la revendication 12, les moyens pour maintenir les moyens de pompage comporte une excavation (50, 52) pratiquée dans le dispositif d'assemblage.

16. Dispositif selon la revendication 15, l'excavation étant à symétrie de révolution autour d'un axe parallèle à un axe longitudinal du dispositif d'assemblage.

17. Dispositif selon la revendication 16, une surface d'extrémité (17) du dispositif (18) de montage définissant un plan ayant une normale inclinée d'un angle θ par rapport à cet axe longitudinal.

18. Dispositif selon la revendication 15, l'excavation étant inclinée d'un angle θ par rapport à un axe longitudinal du dispositif (18) de montage.

19. Dispositif selon la revendication 18, une surface d'extrémité du dispositif de montage définissant un plan normal par rapport à cet axe longitudinal.

**Claims**

1. Device for emitting radiation by optical pumping, including:

   - means (19, 23) for emitting light comprising a first resonant cavity having a first input mirror (3, 12) and an output mirror (4, 11),
   - optical pumping means (21, 26) for emitting a pumping beam of the first cavity, the normal to the input surface of the resonant cavity being inclined at an angle θ with respect to the direction of propagation of the pumping beam (20),
   - means (11, 13) for forming a second resonant cavity for the pumping beam, said means comprising a second input mirror (13) forming said second cavity with the output mirror (11) of the first cavity, **characterised in that** it comprises an optical element (43), transparent to the pumping wavelength between the first (12) and second (13) input mirrors.

2. Device according to claim 1, the angle θ being such that the pumping beam is transmitted in the first cavity through the input mirror with a transmission greater than 50%.

3. Device according to one of claims 1 to 2, comprising Bragg or metallic mirrors.

4. Device according to claims 1 to 3, the angle θ being such that the second cavity being resonant at the wavelength of the optical pumping means.

5. Device according to claims 1 to 4, the reflectivities $R_E$ and $R_S$ of the second input mirror (13) and the output mirror (11) at the wavelength of the pumping laser diode $\lambda_p$ satisfying the condition:

$$R_E = R_S \exp\left(-2\alpha d / \cos\theta'\right),$$

   where $\alpha$ is the absorption coefficient at the pumping wavelength, d is the absorbing thickness and $\theta'$ is the angle of propagation with respect to the normal, of the light in an absorbing medium.

6. Device according to one of claims 1 to 5, the absorption of the pumping beam in the second cavity being greater than 50%.

7. Device according to one of claims 1 to 6, the radiation emitted being emitted primarily according to the fundamental mode of the second resonant cavity.

8. Device according to one of claims 1 to 7, the optical pumping means comprising at least one VCSEL (29).

9. Device according to claim 8, the radiation beam emitted by the first resonant cavity having a diameter smaller than 200 $\mu$m.

10. Device according to one of claims 1 to 9, the emission wavelength of the first cavity being at least partially between 2 $\mu$m and 10 $\mu$m.

11. Optical device comprising a device according to one of claims 1 to 10 and an optical fibre (31) coupled to the output of the first resonant cavity.

12. Device according to one of the claims 1 to 10, comprising a mounting device (18) comprising:

    - means (50, 52) for holding said pumping means in the mounting device,
    - means for holding the radiation emission device (19, 23), so that the normal to the input surface of these radiation emission means is inclined at an angle θ with respect to the direction of propagation of a pumping beam coming from said optical pumping means, **characterised in that** it comprises first and second surfaces, for holding pumping means and the radiation emission device, which two surfaces form an angle θ therebetween.

13. Device according to one of the claims 1 to 10, comprising a mounting device (18) comprising:

- means (50, 52) for holding said pumping means in the mounting device,
- means for holding a radiation emission device (19, 23), so that the normal to the input surface of these radiation emission means is inclined at an angle θ with respect to the direction of propagation of a pumping beam coming from said optical pumping means, **characterised in that** it comprises the growth substrate of a pumping VCSEL.

14. Device according to claim 12, the mounting device (18) comprising the growth substrate of a pumping VCSEL.

15. Device according to claim 12, the means for holding the pumping means comprising a groove (50, 52) formed in the mounting device.

16. Device according to claim 15, the groove having rotational symmetry about an axis parallel to a longitudinal axis of the mounting device (18).

17. Device according to claim 16, an end surface (17) of this mounting device defines a plane having a normal inclined at an angle θ with respect to said longitudinal axis.

18. Device according to claim 15, the groove being inclined at an angle θ with respect to a longitudinal axis of the mounting device.

19. Device according to claim 18, an end surface of this mounting device defining a normal plane with respect to said longitudinal axis.

**Patentansprüche**

1. Optisch gepumpter Strahlungsemitter, umfassend:

    - Lichtemissionseinrichtungen (19, 23) mit einem einen ersten Eingangsspiegel (3, 12) und einen Ausgangsspiegel (4, 11) aufweisenden ersten Hohlraumresonator,
    - optische Pumpeinrichtungen (21, 26) zur Emission eines Pumpstrahls für den ersten Hohlraum, wobei die Normale zur Eingangsfläche des Hohlraums in Bezug auf die Ausbreitungsrichtung des Pumpstrahl (20) um einen Winkel θ geneigt ist,
    - Einrichtungen (11, 13) zur Bildung eines zweiten Hohlraumresonators für den Pumpstrahl, wobei die genannten Einrichtungen einen mit dem Ausgangsspiegel (11) des ersten Hohlraums den zweiten Hohlraum bildenden zweiten Eingangsspiegel (13) umfassen,

    **dadurch gekennzeichnet, dass** er zwischen dem ersten (12) und dem zweiten (13) Eingangsspiegel ein für die Pumpwellenlänge durchlässiges optisches Element (43) umfasst.

2. Vorrichtung nach Anspruch 1, wobei der Winkel θ so ist, dass der Pumpstrahl durch den Eingangsspiegel hindurch mit einer Transmission von mehr als 50 % in den ersten Hohlraum transmittiert wird.

3. Vorrichtung nach einem der Ansprüche 1 bis 2 mit Spiegeln des Bragg- oder metallischen Typs.

4. Vorrichtung nach Anspruch bzw. Ansprüchen 1 bis 3, wobei der Winkel θ so ist, dass der zweite Hohlraum bei der Wellenlänge der optischen Pumpeinrichtungen mischwingt.

5. Vorrichtung nach Anspruch bzw. Ansprüchen 1 bis 4, bei der die Reflektivitäten $R_E$ und $R_S$ des zweiten Eingangsspiegels (13) und des Ausgangsspiegels (11) bei der Wellenlänge der Pumplaserdiode $\lambda_p$ folgende Bedingung erfüllen:

$$R_E = R_S \exp(-2\alpha d/\cos\theta') \qquad (1)$$

wo $\alpha$ der Absorptionskoeffizient bei der Pumpwellenlänge, d die absorbierende Dicke und θ' der Ausbreitungswinkel des Lichts in dem absorbierenden Medium in Bezug auf die Normale ist.

**6.** Vorrichtung nach einem der Ansprüche 1 bis 5, wobei die Absorption des Pumpstrahl in dem zweiten Hohlraum höher als 50 % ist.

**7.** Vorrichtung nach einem der Ansprüchen 1 bis 6, wobei die emittierte Strahlung hauptsächlich der Grundmode des zweiten Hohlraums entspricht.

**8.** Vorrichtung nach einem der Ansprüche 1 bis 7, wobei die optischen Pumpeinrichtungen wenigstens einen VCSEL (29) umfassen.

**9.** Vorrichtung nach Anspruch 8, wobei das durch den ersten Hohlraum emittierte Strahlenbündel einen Durchmesser kleiner als 200 $\mu$m hat.

**10.** Vorrichtung nach einem der Ansprüche 1 bis 9, wobei die Emissionswellenlänge des ersten Resonators wenigstens partiell zwischen 2 $\mu$m und 10 $\mu$m entfalten ist.

**11.** Optische Vorrichtung mit einer Vorrichtung nach einem der Ansprüche 1 bis 10 und einer optischen Faser (31), gekoppelt mit dem Ausgang des ersten Hohlraums.

**12.** Vorrichtung nach einem der Ansprüche 1 bis 10 mit einer Montagevorrichtung (18), umfassend:

- Einrichtungen (50, 52) um die genannten Pumpeinrichtungen in der Montagevorrichtung zu halten,
- Einrichtungen um die Strahlungsemissionsvorrichtungen (19, 23) so zu halten, dass die Normale zur Eingangsfläche dieser Strahlungsemissionseinrichtungen in Bezug auf die Ausbreitungsrichtung eines von den genannten optischen Pumpeinrichtungen stammenden Pumpstrahls um einen Winkel θ geneigt ist,

**dadurch gekennzeichnet, dass** sie zum Halten der Pumpeinrichtungen und der Strahlungsemissionsvorrichtung eine erste und eine zweite Fläche umfasst, wobei diese beiden Flächen zwischen sich einen Winkel θ bilden.

**13.** Vorrichtung nach einem der Ansprüche 1 bis 10 mit einer Montagevorrichtung (18), umfassend:

- Einrichtungen (50, 52) um die genannten Pumpeinrichtungen in der Montagevorrichtung zu halten,
- Einrichtungen um die Strahlungsemissionsvorrichtungen (19, 23) so zu halten, dass die Normale zur Eingangsfläche dieser Strahlungsemissionseinrichtungen in Bezug auf die Ausbreitungsrichtung eines von den genannten optischen Pumpeinrichtungen stammenden Pumpstrahls um einen Winkel θ geneigt ist,

**dadurch gekennzeichnet, dass** sie das Wachstumssubstrat eines Pump-VCSEL umfasst.

**14.** Vorrichtung nach Anspruch 12, bei der die Montagevorrichtung (18) das Wachstumssubstrat eines Pump-VCSEL umfasst.

**15.** Vorrichtung nach Anspruch 12, wobei die Einrichtungen zum Halten der Pumpeinrichtungen eine in der Zusammenbauvorrichtung vorgesehene Ausnehmung (50, 52) umfassen.

**16.** Vorrichtung nach Anspruch 15, wobei die Ausnehmung rotationssymmetrisch um eine Achse ist, die parallel ist zu einer Längsachse der Zusammenbauvorrichtung.

**17.** Vorrichtung nach Anspruch 16, wobei eine Endfläche (17) der Montagevorrichtung (18) eine Ebene mit einer Normalen definiert, die in Bezug auf diese Längsachse um einen Winkel θ geneigt ist.

**18.** Vorrichtung nach Anspruch 15, wobei die Ausnehmung in Bezug auf eine Längsachse der Montagevorrichtung (18) um einen Winkel θ geneigt ist.

**19.** Vorrichtung nach Anspruch 18, wobei eine Endfläche der Montageeinrichtung eine in Bezug auf diese Längsachse normale Ebene definiert.

FIG. 1

FIG. 2

FIG. 3

FIG. 4

FIG. 5A

FIG. 5B

FIG. 6

# FIG. 7

# FIG. 7A

FIG. 8

FIG. 9

**RÉFÉRENCES CITÉES DANS LA DESCRIPTION**

**Documents brevets cités dans la description**

- FR 0116116